# FASCICULE DE BREVET EUROPEEN

(11) **EP 1 186 024 B1**
(45) Date de publication et mention de la délivrance du brevet: **15.11.2006**
(21) Numéro de dépôt: 00940457.5
(22) Date de dépôt: 08.06.2000
(51) Int. Cl.: H01L 21/762, H01L 21/20

(54) **PROCEDE DE FABRICATION D'UN SUBSTRAT DE SILICIUM COMPORTANT UNE MINCE COUCHE D'OXYDE DE SILICIUM ENSEVELIE**
HERSTELLUNGSVERFAHREN FÜR EIN SILIZIUMSUBSTRAT MIT EINER DÜNNEN, VERGRABENEN SILIZIUMOXIDSCHICHT
METHOD FOR MAKING A SILICON SUBSTRATE COMPRISING A BURIED THIN SILICON OXIDE FILM

(30) Priorité: 14.06.1999 FR 9907496
(43) Date de publication de la demande: 13.03.2002
(73) Titulaire: Fahrenheit Thermoscope LLC, Las Vegas, NV 89119 (US)
(72) Inventeur: JURCZAK, Malgorzata, 38000 Grenoble (FR); SKOTNICKI, Thomas, F-38920 Crolles-Montfort (FR)
(74) Mandataire: Casalonga, Axel
(86) Numéro de dépôt international: PCT/FR2000/001570
(87) Numéro de publication internationale: WO 2000/077846

(56) Documents cités:
- EP-A- 0 371 862
- EP-A- 0 779 649
- WO-A-96/15550

## Description

La présente invention concerne d'une manière générale un procédé de fabrication d'un substrat de silicium comportant une mince couche d'oxyde de silicium ensevelie (substrat SOI) et en particulier un tel procédé qui permet l'obtention d'un substrat SOI comportant une couche d'oxyde de silicium ensevelie extrêmement mince et d'excellente uniformité.

Les techniques de fabrication de substrat SOI connues présentent toutes un certain nombre d'inconvénients, en particulier un faible rendement de production, une qualité encore insuffisante du substrat et l'obtention de couches minces de Si et d'oxyde de silicium ensevelie d'épaisseur relativement importante et d'uniformité médiocre.

Un premier procédé de fabrication de substrat SOI, connu sous le nom de "Technologie SIMOX", consiste à former la couche de SiO₂ ensevelie dans un substrat de silicium par une étape d'implantation d'oxygène à dose élevée suivie d'un recuit à une température supérieure à 1300°C. Un inconvénient majeur de ce procédé est qu'il nécessite un équipement non standard. En outre, la durée du processus d'implantation d'oxygène à dose élevée réduit très sensiblement le rendement de production.

Les substrats obtenus par ce procédé souffrent également d'une qualité insuffisante de la couche d'oxyde de silicium ensevelie et de la mince couche de silicium (densité élevée de trous d'épingles).

Enfin, ce procédé, du fait que les couches minces (couche mince de Si et couche mince ensevelie d'oxyde de silicium) sont déterminées par le processus d'implantation, permet difficilement d'atteindre des épaisseurs inférieures à 50 nm pour la mince couche de silicium et 80 nm pour la couche de SiO₂ ensevelie.

Un second procédé connu sous le nom de "Technique BESOI", consiste à former sur une surface d'un premier corps de silicium un mince film de SiO₂, puis à réunir ce premier corps, par le mince film de SiO₂, à un second corps de silicium et enfin à éliminer par meulage et polissage mécanique une partie d'un des corps de silicium pour former la mince couche de silicium au-dessus de la couche d'oxyde de silicium ensevelie.

La couche d'oxyde de silicium sur le premier corps de silicium est formée par successivement l'oxydation de la surface de ce premier corps, puis une attaque de la couche d'oxyde formée pour obtenir l'épaisseur voulue.

Ce procédé ne permet d'obtenir que des couches d'oxyde de silicium ensevelies et des couches de silicium sur l'oxyde de silicium enseveli relativement épaisses du fait du mauvais contrôle du procédé d'attaque. En outre, les couches minces obtenues par ce procédé présentent une mauvaise uniformité.

Un troisième procédé, connu sous le nom de "Technologie SMART CUT" consiste à former par oxydation sur un premier corps de silicium, une couche mince d'oxyde de silicium puis à implanter des ions H⁺ dans le premier corps de silicium pour former dans ce premier corps de silicium sous la mince couche d'oxyde de silicium un plan de cavités, à réunir, par la mince couche d'oxyde de silicium, ce premier corps à un deuxième corps de silicium, puis à soumettre l'ensemble à une activation thermique pour transformer le plan de cavités en un plan de coupe, permettant de récupérer d'une part un substrat SOI et, d'autre part, un corps de silicium réutilisable.

Ce procédé nécessite l'implantation d'une dose élevée d'atomes d'hydrogène. En dépit de l'utilisation d'atomes de plus petite taille pour l'implantation, la surface de la couche mince de silicium obtenue est également endommagée. En outre, puisque l'épaisseur de la couche mince de silicium est définie par l'énergie d'implantation des atomes d'hydrogène, cette épaisseur peut difficilement être inférieure à 50 nm environ.

Les procédés ci-dessus sont décrits, en particulier, dans l'article SOI : Materials to Systems (SOI : matériaux à systèmes) A.J. Auberton-Hervé, 1996 IEEE.

WO-A-9615550 décrit un procédé de fabrication d'un substrat SOI. Le procédé consiste à former sur une surface d'un premier corps de silicium une mince couche d'oxyde de silicium, à former sur une surface d'un second corps de silicium, dans l'ordre, une mince couche d'oxyde de silicium et une mince couche en alliage de silicium, de germanium et de carbone, puis à réunir le premier corps au second corps par les minces couches d'oxyde de silicium, à éliminer le second corps jusqu'à la mince couche en alliage de silicium, de germanium et de carbone, et enfin à éliminer ladite mince couche en alliage.

La présente invention a donc pour objet de fournir un procédé de fabrication d'un substrat SOI, qui remédie aux inconvénients des procédés de l'art antérieur.

En particulier, la présente invention a pour objet un procédé de fabrication d'un substrat SOI qui permette d'obtenir des couches d'oxyde de silicium et des couches de silicium sur la couche d'oxyde ensevelie très minces et de très bonne uniformité.

L'invention a également pour objet de fournir un procédé de fabrication d'un substrat SOI qui puisse être mis en oeuvre dans un équipement standard.

Selon une première réalisation de l'invention, le procédé de fabrication d'un substrat de silicium comportant une mince couche d'oxyde de silicium ensevelie, comprend :
a) la réalisation d'un premier élément comprenant un corps de silicium dont une surface principale est revêtue, dans l'ordre, d'une couche tampon en germanium ou en alliage de germanium et de silicium et d'une mince couche de silicium;
b) la réalisation d'un second élément, distinct du premier élément, comprenant un corps de silicium dont une surface principale est revêtue d'une mince couche d'oxyde de silicium;
c) la liaison du premier élément au second élément de telle sorte que la mince couche de silicium du premier élément soit en contact avec la mince couche d'oxyde de silicium du second élément; et
d) l'élimination de la couche tampon en germanium ou en alliage de germanium et de silicium, pour récupérer le substrat de silicium comportant une mince couche d'oxyde de silicium ensevelie, d'une part, et un substrat de silicium réutilisable, d'autre part.

Selon une seconde réalisation de l'invention, le procédé de fabrication d'un substrat de silicium comportant une mince couche d'oxyde de silicium ensevelie, comprend :
a) la réalisation d'un premier élément comprenant un corps de silicium ayant une surface principale revêtue, dans l'ordre, d'une couche tampon en germanium ou en un alliage de germanium et de silicium, d'une mince couche de silicium et d'une mince couche d'oxyde de silicium;
b) la réalisation d'un second élément comprenant un corps de silicium dont une surface principale est revêtue d'une mince couche d'oxyde de silicium;
c) la liaison du premier élément au second élément, de telle sorte que la mince couche d'oxyde de silicium du premier élément soit en contact avec la mince couche d'oxyde de silicium du second élément; et
d) l'élimination de la couche tampon pour récupérer le substrat de silicium comportant une mince couche d'oxyde de silicium ensevelie, d'une part, et un substrat de silicium réutilisable, d'autre part.

Dans un troisième mode de réalisation de l'invention, le procédé de fabrication d'un substrat de silicium comportant une mince couche d'oxyde de silicium ensevelie, comprend :
a) la réalisation d'un premier élément comprenant un corps de silicium ayant une surface principale revêtue, dans l'ordre, d'une couche tampon de germanium ou d'un alliage de germanium et de silicium, d'une mince couche de silicium et d'une mince couche d'oxyde de silicium;
b) la réalisation d'un second élément constitué par un corps de silicium;
c) la liaison du premier élément au second élément de telle sorte que la mince couche d'oxyde de silicium du premier élément soit en contact avec le corps de silicium du second élément; et
d) l'élimination de la couche tampon pour récupérer le substrat de silicium comportant une mince couche d'oxyde de silicium ensevelie, d'une part, et un substrat de silicium réutilisable, d'autre part.

Les minces couches tampon en Ge et alliages de germanium et de silicium du premier élément, sont réalisées de préférence par dépôt épitaxial, par exemple par des procédés bien connus de dépôts en phase vapeur ou d'épitaxie par faisceau moléculaire, de sorte que, en particulier, la couche mince de silicium peut avoir une épaisseur très faible de quelques nanomètres tout en ayant une uniformité convenable, typiquement de 1 à 50 nm.

La mince couche d'oxyde ensevelie est de préférence réalisée par un procédé d'oxydation thermique connu, de sorte que l'on peut obtenir une couche d'oxyde de très haute qualité avec une épaisseur pratiquement arbitraire pouvant varier de 2 nm à 400 nm.

Comme cela est connu en soi, la liaison du premier et du second éléments peut s'effectuer en utilisant les forces de Van der Waals. Eventuellement, pour accroître la résistance mécanique à l'interface entre les éléments, l'ensemble peut être soumis à un recuit.

La couche tampon du premier élément peut être constituée de germanium pur, d'un alliage de silicium et de germanium ou d'un alliage de silicium-germanium contenant du carbone. Plus particulièrement, on peut utiliser des alliages Si₁₋ₓGeₓ (0<x<1) ou des alliages Si_{1-x-y}GeₓC_{y} (0<x≤0,95 et 0<y≤0,05).

Comme cela est connu, le germanium ainsi que les alliages Si₁₋ₓGeₓ et Si_{1-x-y}GeₓC_{y} présentent une très grande sélectivité à l'attaque chimique par des solutions ou à une attaque anisotropique par plasma. Dans le cas des alliages silicium-germanium, afin d'obtenir une attaque de sélectivité élevée, il est préférable que la proportion de germanium dans l'alliage soit au moins égale à 10% en poids, de préférence égale ou supérieure à 30% en poids.

L'emploi d'alliage de silicium-germanium renfermant une petite fraction de carbone, permet de réduire les contraintes élevées entre les couches de silicium et la couche tampon. Ainsi, il est possible d'utiliser des alliages à des concentrations plus élevées en germanium et par conséquent avec une meilleure sélectivité d'attaque, tout en obtenant une relaxation des contraintes. Il est également possible de former une couche tampon en alliage de silicium-germanium présentant un gradient de concentration en germanium (couche tampon SiGe relaxée). Dans ce type de couche tampon, la concentration en germanium augmente à partir du corps de silicium du premier élément.

On peut ainsi réaliser des couches tampon relativement épaisses, ce qui peut accroître de façon significative la vitesse d'attaque, mais qui en dépit de son épaisseur, présente une surface exempte de dislocations (toutes les dislocations et défauts étant situés dans la partie basse de la couche tampon), ce qui assure de bonnes conditions et une bonne continuité pour la croissance épitaxiale de la couche mince monocristalline de silicium devant être déposée ultérieurement.

Dans la couche d'alliage SiGe, le profil de concentration du germanium peut être non uniforme. Ainsi, au fond de la couche, la concentration en Ge peut être 0% puis s'accroître jusqu'à 50% (ou 70% et même 100%) et ensuite décroître jusqu'à 0%. Cette solution permet d'éviter des déformations dans la couche supérieure de silicium et d'éliminer les limitations d'épaisseur. Une fraction molaire élevée de Ge dans l'alliage SiGe (en particulier au milieu de la couche) fournit, d'une part une sélectivité très élevée du procédé de gravure et une absence de risque de relaxation du film de Si, d'autre part.

La suite de la description se réfère aux figures annexées, qui représentent :
Figures la à le - les étapes principales d'une première réalisation du procédé de l'invention; et

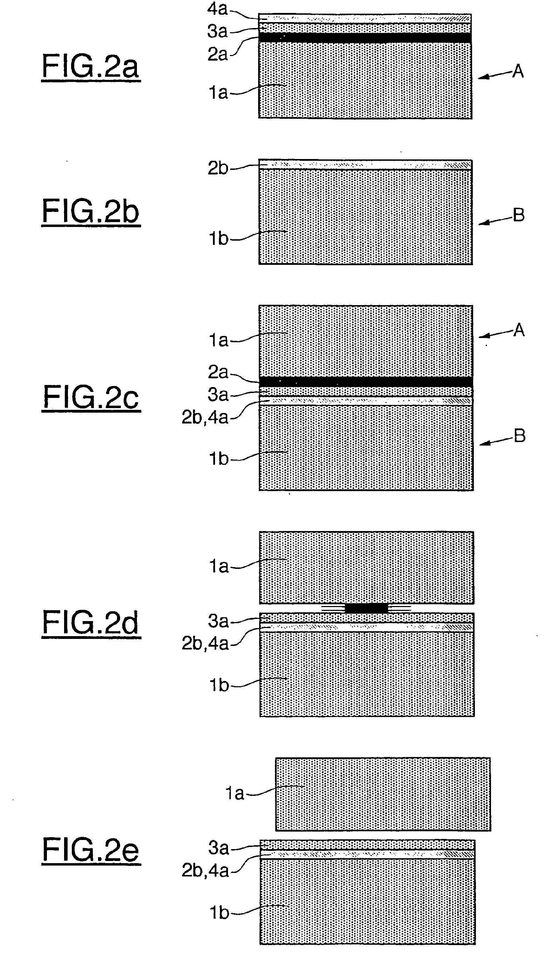

Figures 2a à 2e - les étapes principales d'une seconde réalisation du procédé de l'invention.

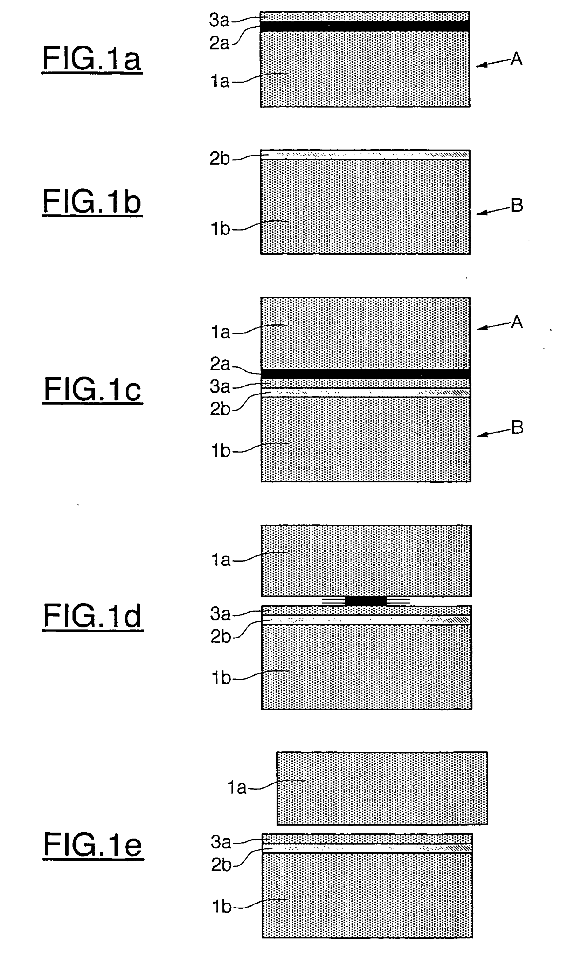

En se référant aux figures la à le, le premier mode de réalisation du procédé de l'invention débute, comme le montre la figure 1a, par le dépôt successif par épitaxie (par exemple par dépôt chimique en phase vapeur ou par épitaxie par faisceau moléculaire) d'une couche 2a de germanium, alliage silicium-germanium éventuellement incluant une faible proportion de carbone, puis d'une couche mince de silicium 3a.

Typiquement, les couches tampon 2a et de silicium 3a ont une épaisseur de 1 à 50 nm. On réalise ainsi un premier élément A comprenant un corps de silicium 1 a ayant une surface principale revêtue, dans l'ordre, d'une couche tampon en germanium ou en un alliage de germanium et de silicum 2a et d'une mince couche de silicium 3a.

D'autre part, on forme sur un corps de silicium 1b, distinct du corps de silicium précédent, par un procédé classique d'oxydation thermique, une couche d'oxyde de silicium mince 2b, de manière à obtenir un second élément B comprenant un corps de silicium 1b dont une surface principale est revêtue d'une mince couche d'oxyde de silicium 2b.

A ce stade, on réunit, comme le montre la figure 1c, le premier élément A et le deuxième élément B, de telle sorte que la mince couche 3a de silicium du premier élément A soit en contact avec la couche d'oxyde de silicium 2b du second élément B et les premier et second éléments A et B sont liés l'un à l'autre, de manière connue, en utilisant les forces de Van der Waals.

On procède alors, comme le montre la figure 1d, à l'élimination sélective de la couche tampon 2a, par exemple au moyen d'une chimie oxydante bien connue, telle qu'une solution 40 ml HNO₃ 70% + 20 ml H₂O₂ + 5 ml HF 0,5% ou par une attaque anisotropique par plasma également bien connue.

Une fois la couche tampon 2a totalement éliminée, on obtient, comme représenté à la figure le, un substrat de silicium comprenant une couche d'oxyde de silicium 2b ensevelie.

Le substrat SOI obtenu ne nécessite pas de polissage supplémentaire comme c'était le cas dans les techniques de l'art antérieur, en particulier les techniques dites "BESOI" et "SMART CUT".

Enfin, le corps de silicium la n'est pas perdu et peut être recyclé pour être utilisé, par exemple comme corps de silicium pour la fabrication des éléments A ou B.

On a représenté aux figures 2a à 2e les étapes principales d'une variante du procédé décrit précédemment. Le procédé de cette variante diffère du procédé décrit en liaison avec les figures la à le en ce qu'on a fait croître, par oxydation thermique, sur la mince couche de silicium 3a du premier élément A précédent, une mince couche d'oxyde de silicium 4a de manière à obtenir un premier élément A comportant un substrat de silicium 1a dont une surface principale est revêtue, dans l'ordre, d'une couche tampon en germanium ou alliage de silicium et germanium 2a, une mince couche de silicium 3 a et finalement d'une mince couche d'oxyde de silicium 4a.

Le second élément B, représenté à la figure 2b, est identique à celui du procédé précédent.

Le premier élément A et le second élément B sont alors réunis comme précédemment, de telle sorte que la couche 4a d'oxyde de silicium du premier élément A soit au contact de la couche 2b de silicium du second élément B.

Bien que, dans ce cas, le premier élément A et le second élément B puissent être réunis au moyen de forces de Van der Waals, il est préférable pour assurer une bonne liaison mécanique des éléments, de soumettre l'ensemble à un traitement thermique. Par exemple, on peut chauffer l'ensemble à une température de 1000°C pendant une durée d'environ 30 minutes (comme dans la technologie BESOI).

Le procédé s'achève comme précédemment et tel que représenté aux figures 2d et 2e, par l'élimination de la couche tampon, de manière à obtenir également comme précédemment un substrat SOI comportant une couche de silicium ensevelie constituée par la réunion des couches d'oxyde de silicium 3a et 2b des premier et second éléments et un substrat de silicium 1a, réutilisable.

En procédant ainsi, on améliore encore la qualité de l'interface entre la couche d'oxyde de silicium ensevelie 4a, 2b, et la mince couche de silicium 3a au-dessus de celle-ci.

Dans une autre variante du procédé de l'invention, on peut procéder de la même manière que décrit en liaison aux figures 2a à 2e, mais en utilisant un second élément B uniquement constitué par un substrat de silicium.

## Revendications

1. Procédé de fabrication d'un substrat de silicium comportant une mince couche d'oxyde de silicium ensevelie, comprenant :
a) la réalisation d'un premier élément (A) comprenant un premier corps de silicium (1a) dont une surface principale est revêtue, dans l'ordre, d'une couche tampon (2a) en germanium ou en un alliage de germanium et de silicium et d'une mince couche de silicium (3a);
b) la réalisation d'un second élément (B), comprenant un second corps de silicium (1b) dont une surface principale est revêtue d'une mince couche d'oxyde de silicium (2b);
c) la liaison du premier élément (A) au second élément (B) de telle sorte que la mince couche de silicium (3a) du premier élément (A) soit en contact avec la mince couche d'oxyde de silicium (2b) du second élément (B); et
d) l'élimination de la couche tampon (2a) pour récupérer le substrat de silicium comportant une mince couche d'oxyde de silicium ensevelie, d'une part, et un substrat de silicium réutilisable, d'autre part.

2. Procédé de fabrication d'un substrat de silicium comportant une mince couche d'oxyde de silicium ensevelie, comprenant :
a) la réalisation d'un premier élément (A) comprenant un premier corps de silicium (1a) ayant une surface principale revêtue, dans l'ordre, d'une couche tampon (2a) en germanium ou en un alliage de germanium et de silicium, d'une mince couche de silicium (3a) et d'une mince couche d'oxyde de silicium (4a);
b) la réalisation d'un second élément (B) comprenant un second corps de silicium (1b) dont une surface principale est revêtue d'une mince couche d'oxyde de silicium (2b);
c) la liaison du premier élément (A) au second élément (B), de telle sorte que la mince couche d'oxyde de silicium (4a) du premier élément soit en contact avec la mince couche d'oxyde de silicium (2b) du second élément (B); et
d) l'élimination de la couche tampon (2a) pour récupérer le substrat de silicium comportant une mince couche d'oxyde de silicium ensevelie, d'une part, et un substrat de silicium réutilisable, d'autre part.

3. Procédé de fabrication d'un substrat de silicium comportant une mince couche d'oxyde de silicium ensevelie, comprenant :
a) la réalisation d'un premier élément (A) comprenant un corps de silicium (1a) dont une surface principale est revêtue, dans l'ordre, d'une couche tampon (2a) en germanium ou en un alliage de germanium et de silicium, d'une mince couche de silicium (3a) et d'une mince couche d'oxyde de silicium (4a);
b) l'obtention d'un second élément (B) comprenant uniquement un corps de silicium (1b),
c) la liaison du premier élément (A) au second élément (B) de telle sorte que la mince couche d'oxyde de silicium (4a) du premier élément soit en contact avec le corps de silicium (1b) du second élément (B); et
d) l'élimination de la couche tampon (2a) pour récupérer le substrat de silicium comportant une mince couche d'oxyde de silicium ensevelie, d'une part, et un substrat de silicium réutilisable, d'autre part.

4. Procédé selon l'une quelconque des revendications précédentes, **caractérisé en ce que** la couche tampon est constituée d'un alliage de silicium et de germanium choisi parmi les alliages Si₁₋ₓGeₓ (0<x<1) et Si_{1-x-y}GeₓC_{y} (0<x<0,95 ; 0<y≤0,05).

5. Procédé selon l'une quelconque des revendications précédentes, **caractérisé en ce que** les alliages de germanium et de silicium comportent au moins 10% en poids, de préférence au moins 30% en poids de germanium.

6. Procédé selon l'une quelconque des revendications 1 à 4, **caractérisé en ce que** la couche tampon est une couche en alliage de silicium et de germanium présentant un gradient de concentration en germanium.

7. Procédé selon l'une quelconque des revendications précédentes, **caractérisé en ce que** la couche tampon (2a) et la mince couche de silicium (3a) du premier élément (A) sont formées par dépôt épitaxial.

8. Procédé selon la revendication 7, **caractérisé en ce que** le dépôt épitaxial est un dépôt chimique en phase vapeur ou un dépôt épitaxial par faisceau moléculaire.

9. Procédé selon l'une quelconque des revendications précédentes, **caractérisé en ce que** les couches d'oxyde de silicium sont formées par oxydation thermique.

10. Procédé selon l'une quelconque des revendications précédentes, **caractérisé en ce que** l'étape (d) d'élimination de la couche tampon (2a) s'effectue par dissolution sélective de cette couche au moyen d'une solution oxydante ou par attaque anisotropique par plasma.

## Claims

1. Method of fabricating a silicon substrate comprising a thin buried silicon oxide layer, comprising:
a) the production of a first element (A) comprising a first silicon body (1a), a main surface of which is coated with a buffer layer (2a) made of germanium or of a germanium-silicon alloy and a thin silicon layer (3a), in that order;
b) the production of a second element (B), comprising a second silicon body (1b), a main surface of which is coated with a thin silicon oxide layer (2b);
c) the bonding of the first element (A) to the second element (B) such that the thin silicon layer (3a) of the first element (A) is in contact with the thin silicon oxide layer (2b) of the second element (B); and
d) the removal of the buffer layer (2a) in order to recover the silicon substrate comprising a thin buried silicon oxide layer, on the one hand, and a reuseable silicon substrate, on the other hand.

2. Method of fabricating a silicon substrate comprising a thin buried silicon oxide layer, comprising:
a) the production of a first element (A) comprising a first silicon body (1a) having a main surface coated with a buffer layer (2a) made of germanium or of a germanium-silicon alloy, a thin silicon layer (3a) and a thin silicon oxide layer (4a), in that order;
b) the production of a second element (B) comprising a second silicon body (1b), a main surface of which is coated with a thin silicon oxide layer (2b);
c) the bonding of the first element (A) to the second element (B), such that the thin silicon oxide layer (4a) of the first element is in contact with the thin silicon oxide layer (2b) of the second element (B); and
d) the removal of the buffer layer (2a) in order to recover the silicon substrate comprising a thin buried silicon oxide layer, on the one hand, and a reuseable silicon substrate, on the other hand.

3. Method of fabricating a silicon substrate comprising a thin buried silicon oxide layer, comprising:
a) the production of a first element (A) comprising a silicon body (1a), a main surface of which is coated with a buffer layer (2a) made of germanium or of a germanium-silicon alloy, a thin silicon layer (3a) and a thin silicon oxide layer (4a), in that order;
b) the obtaining of a second element (B) comprising only a silicon body (1b)
c) the bonding of the first element (A) to the second element (B) such that the thin silicon oxide layer (4a) of the first element is in contact with the silicon body (1b) of the second element (B); and
d) the removal of the buffer layer (2a) in order to recover the silicon substrate comprising a thin buried silicon oxide layer, on the one hand, and a reuseable silicon substrate, on the other hand.

4. Method according to any one of the preceding claims, **characterized in that** the buffer layer consists of a silicon-germanium alloy chosen from the alloys Si₁₋ₓGeₓ ( 0<x<1) and Si_{1-x-y}GeₓC_{y} (0<x<0.95; 0<y≤0.05).

5. Method according to any one of the preceding claims, **characterized in that** the germanium-silicon alloys comprise at least 10% by weight and preferably at least 30% by weight of germanium.

6. Method according to any one of Claims 1 to 4, **characterized in that** the buffer layer is a layer made of a silicon-germanium alloy having a germanium concentration gradient.

7. Method according to any one of the preceding claims, **characterized in that** the buffer layer (2a) and the thin silicon layer (3a) of the first element (A) are formed by epitaxial deposition.

8. Method according to Claim 7, **characterized in that** the epitaxial deposition is chemical vapour deposition or molecular beam epitaxial deposition.

9. Method according to any one of the preceding claims, **characterized in that** the silicon oxide layers are formed by thermal oxidation.

10. Method according to any one of the preceding claims, **characterized in that** the step (d) of removing the buffer layer (2a) is carried out by selective dissolution of this layer by means of an oxidizing solution or by anisotropic plasma etching.

## Patentansprüche

1. Verfahren zur Herstellung eines Siliziumsubstrats, das eine dünne Hilfsschicht aus Siliziumoxid enthält, umfassend:
a) Realisierung eines ersten Elements (A), umfassend einen ersten Siliziumkörper (1a), bei dem eine Hauptfläche der Reihe nach mit einer Pufferschicht (2a) aus Germanium oder aus einer Legierung aus Germanium und aus Silizium sowie mit einer dünnen Schicht aus Silizium (3a) versehen ist,
b) Realisierung eines zweiten Elements (B), umfassend einen zweiten Siliziumkörper (1b), bei dem eine Hauptfläche mit einer dünnen Schicht aus Siliziumoxid (2b) versehen ist,
c) Bindung des ersten Elements (A) an das zweite Element (B), so daß sich die dünne Schicht aus Silizium (3a) des ersten Elements (A) in Kontakt mit der dünnen Schicht aus Siliziumoxid (2b) des zweiten Elements (B) befindet, sowie
d) Entfernung der Pufferschicht (2a), um das Siliziumsubstrat, das einerseits eine dünne Hilfsschicht aus Siliziumoxid und andererseits ein wiederverwendbares Siliziumsubstrat enthält, zurückzugewinnen.

2. Verfahren zur Herstellung eines Siliziumsubstrats, das eine dünne Hilfsschicht aus Siliziumoxid enthält, umfassend:
a) Realisierung eines ersten Elements (A), umfassend einen ersten Siliziumkörper (1a) mit einer Hauptfläche, die der Reihe nach mit einer Pufferschicht (2a) aus Germanium oder aus einer Legierung aus Germanium und aus Silizium, mit einer dünnen Schicht aus Silizium (3a) sowie einer dünnen Schicht aus Siliziumoxid (4a) versehen ist,
b) Realisierung eines zweiten Elements (B), umfassend einen zweiten Siliziumkörper (1b), bei dem eine Hauptfläche mit einer dünnen Schicht aus Siliziumoxid (2b) versehen ist,
c) Bindung des ersten Elements (A) an das zweite Element (B), so daß sich die dünne Schicht aus Siliziumoxid (4a) des ersten Elements in Kontakt mit der dünnen Schicht aus Siliziumoxid (2b) des zweiten Elements (B) befindet, sowie
d) Entfernung der Pufferschicht (2a), um das Siliziumsubstrat, das einerseits eine dünne Hilfsschicht aus Siliziumoxid und andererseits ein wiederverwendbares Siliziumsubstrat enthält, zurückzugewinnen.

3. Verfahren zur Herstellung eines Siliziumsubstrats, das eine dünne Hilfsschicht aus Siliziumoxid enthält, umfassend:
a) Realisierung eines ersten Elements (A), umfassend einen Siliziumkörper (1a), von dem eine Hauptfläche, die der Reihe nach mit einer Pufferschicht (2a) aus Germanium oder aus einer Legierung aus Germanium und aus Silizium, mit einer dünnen Schicht aus Silizium (3a) sowie einer dünnen Schicht aus Siliziumoxid (4a) versehen ist,
b) Gewinnung eines zweiten Elements (B), das nur einen Siliziumkörper (1b) umfasst,
c) Bindung des ersten Elements (A) an das zweite Element (B), so daß sich die dünne Schicht aus Siliziumoxid (4a) des ersten Elements in Kontakt mit dem Siliziumkörper (16) des zweiten Elements (B) befindet, sowie
d) Entfernung der Pufferschicht (2a), um das Siliziumsubstrat, das einerseits eine dünne Hilfsschicht aus Siliziumoxid und andererseits ein wiederverwendbares Siliziumsubstrat enthält, zurückzugewinnen.

4. Verfahren nach einem der vorhergehenden Ansprüche, **dadurch gekennzeichnet, daß** die Pufferschicht aus einer Legierung aus Silizium und aus Germanium besteht, die ausgewählt wurde aus den Legierungen Si₁₋ₓGeₓ (0 < x < 1) und Si_{1-x-y}GeₓC_{y} (0 < x < 0,95 ; 0 < y s 0,05).

5. Verfahren nach einem der vorhergehenden Ansprüche, **dadurch gekennzeichnet, daß** die Legierungen aus Germanium und aus Silizium mindestens 10 ,Gewichtsprozent, vorzugsweise mindestens 30 Gewichtsprozent Germanium enthalten.

6. Verfahren nach einem der Ansprüche 1 bis 4, **dadurch gekennzeichnet, daß** die Pufferschicht eine Schicht aus einer Legierung aus Silizium und aus Germanium ist, die einen Gradienten der Konzentration von Germanium aufweist.

7. Verfahren nach einem der vorhergehenden Ansprüche, **dadurch gekennzeichnet, daß** die Pufferschicht (2a) und die dünne Siliziumschicht (3a) des ersten Elements (A) durch epitaktische Abscheidung gebildet ist.

8. Verfahren nach Anspruch 7, **dadurch gekennzeichnet, daß** die epitaktische Abscheidung eine chemische Dampfabscheidung oder eine epitaktische Abscheidung durch Molekularstrahl ist.

9. Verfahren nach einem der vorhergehenden Ansprüche, **dadurch gekennzeichnet, daß** die Schichten aus Siliziumoxid durch thermische Oxidation gebildet sind.

10. Verfahren nach einem der vorhergehenden Ansprüche, **dadurch gekennzeichnet, daß** die Phase (d) der Entfernung der Pufferschicht (2a) durch gezielte Auflösung dieser Schicht mit Hilfe einer Oxidationslösung oder durch anisotropes Ätzen durch Plasma erfolgt.
